Europäisches Patentamt

(19) European Patent Office

Office européen des brevets

(11) Veröffentlichungsnummer: **0 006 624**
**B1**

(12) **EUROPÄISCHE PATENTSCHRIFT**

(45) Veröffentlichungstag der Patentschrift:
16.05.84

(51) Int. Cl.³: **G 10 K 11/34, H 01 L 41/22**

(21) Anmeldenummer: **79102164.5**

(22) Anmeldetag: **28.06.79**

(54) **Verfahren zur Herstellung von Ultraschallköpfen.**

(30) Priorität: **05.07.78 DE 2829539**

(43) Veröffentlichungstag der Anmeldung:
**09.01.80 Patentblatt 80/1**

(45) Bekanntmachung des Hinweises auf die Patenterteilung:
**16.05.84 Patentblatt 84/20**

(84) Benannte Vertragsstaaten:
**AT CH GB**

(56) Entgegenhaltungen:
**DE - B - 2 829 539**
**DE - B - 2 829 569**

(73) Patentinhaber: **SIEMENS AKTIENGESELLSCHAFT,
Berlin und München Wittelsbacherplatz 2,
D-8000 München 2 (DE)**

(72) Erfinder: **Sachs, Bertram, Dorfstrasse 30,
D-8520 Erlangen (DE)**

## Verfahren zur Herstellung von Ultraschallköpfen

Die Erfindung bezieht sich auf ein Verfahren zur Herstellung von Ultraschallköpfen mit einem Trägerteil und einem Wandlerkamm, insbesondere für ein Ultraschall-Array oder einen Compound-Scanner, wobei der Wandlerkamm aus einer vorgegebenen Anzahl von aneinandergereihten piezoelektrischen Wandlerelementen vorbestimmter Breite, Höhe und Länge und aus jeweils zwischen benachbarten Wandlerelementen angeordneten Abstandselementen mit vorbestimmter Breite besteht.

Ein Ultraschallkopf mit einer linearen Anordnung von piezoelektrischen Wandlerelementen und dazwischen liegenden Abstandselementen ist aus dem Aufsatz von J. C. Somer mit dem Titel »Electronic Sector Scanning for Ultrasonic Diagnosis« aus »Ultrasonics«, July 1968, pp. 153—159 bekannt. Ein Verfahren zur Herstellung eines solchen Ultraschallkopfes wird in dieser Literaturstelle im einzelnen nicht beschrieben.

Der Ultraschallkopf kann nach der eingangs gegebenen Definition ein beliebig geformter Abtastkopf für B-Scan oder aber auch für A-Scan oder für ein ähnliches Abtastverfahren sein. Es kann sich im vorliegenden Fall also auch um einen Ultraschallkopf für Compound-Scan handeln.

Aufgabe der Erfindung ist die Angabe eines Verfahrens der eingangs genannten Art, das eine technisch besonders einfache und kostensparende Herstellung von Ultraschallköpfen ermöglicht.

Gemäß einer ersten Ausführung, die sich insbesondere auf Ultraschall-Arrays erstreckt, wird diese Aufgabe erfindungsgemäß gelöst durch die folgenden Verfahrensschritte:

a) eine der vorgegebenen Anzahl gleiche Zahl von dünnen Folien aus piezoelektrischem Wandlermaterial wird unter abwechselnder Zwischenlagerung von Abstandsstreifen in haftender Verbindung zu einem Paket mit der Breite des fertigen Wandlerkammes zusammengefügt, wobei die Dicke der Folien jeweils genauso groß ist wie die vorbestimmte Breite der Wandlerelemente, wobei die Breite der Folien jeweils genauso groß ist wie die vorbestimmte Höhe der Wandlerelemente, während die Länge der Folien ein Mehrfaches der Länge des fertigen Wandlerkammes beträgt, und wobei die Folien an ihren langgestreckten Längsseiten durch Silberbeläge kontaktbeschichtet sind;

b) das Paket wird in eine Vielzahl von Einzelpaketen mit der Länge der fertigen Wandlerkämme zerschnitten;

c) vor oder nach dem Zerschneiden in Einzelpakete wird das Paket bzw. jedes der Einzelpakete mit einem Trägerteil verbunden; und

d) die Silberbeläge der Folien werden mit Signalsteuerleitungen verbunden.

Gemäß einer weiteren Ausführung, die sich ebenfalls insbesondere auf Ultraschall-Arrays bezieht, wird diese Aufgabe erfindungsgemäß gelöst durch die folgenden Verfahrensschritte:

a) eine der vorgegebenen Anzahl gleiche Zahl von dünnen Folien aus piezoelektrischem Wandlermaterial wird unter abwechselnder Zwischenlagerung von Abstandsstreifen in haftender Verbindung zu einem Paket mit der Breite des fertigen Wandlerkammes zusammengefügt, wobei die Dicke der Folien jeweils genau so groß ist wie die vorbestimmte Breite der Wandlerelemente, wobei die Breite der Folien jeweils genauso groß ist wie die vorbestimmte Höhe der Wandlerelemente, während die Länge der Folien ein Mehrfaches der Länge des fertigen Wandlerkammes beträgt;

b) nach Fertigstellung des Paketes werden die Folien an ihren langgestreckten Längsseiten durch Silberbeläge kontaktbeschichtet;

c) das Paket wird in eine Vielzahl von Einzelpaketen mit der Länge der fertigen Wandlerkämme zerschnitten;

d) vor oder nach dem Zerschneiden in Einzelpakete wird das Paket bzw. jedes der Einzelpakete mit einem Trägerteil verbunden; und

e) die Silberbeläge der Folien werden mit Signalsteuerleitungen verbunden.

Gemäß einer dritten Ausführung, die sich insbesondere auf Compound-Scanner bezieht, wird diese Aufgabe erfindungsgemäß gelöst durch die folgenden Verfahrensschritte:

a) eine der vorgegebenen Anzahl gleiche Zahl von dünnen Folien aus piezoelektrischem Wandlermaterial wird unter abwechselnder Zwischenlagerung von Abstandsstreifen in haftender Verbindung zu einem Paket mit dem Querschnitt des fertigen Wandlerkammes zusammengefügt, während die Länge der Folien und der Abstandsstreifen ein Mehrfaches der Länge der fertigen Wandlerkämme beträgt;

b) das Paket wird in eine Vielzahl von Einzelpaketen mit der Länge der fertigen Wandlerkämme zerschnitten;

c) nach Fertigstellung der Einzelpakete werden die Folien an ihren Querseiten durch Silberbeläge kontaktbeschichtet; und

d) jedes Einzelpaket wird mit einem Trägerteil verbunden.

Aus der nachfolgenden Beschreibung und Zeichnung sind Ausführungsbeispiele der Erfindung ersichtlich. Es zeigt

Fig. 1 ein Herstellungsverfahren gemäß der Erfindung für einen Ultraschallkopf in Form eines Ultraschall-Arrays,

Fig. 2 den Verfahrensschritt einer Kontaktierung von Einzelpaketen,

Fig. 3 ein Herstellungsverfahren nach der Erfindung für ein Rundpaket,

Fig. 4 einen Compound-Scanner mit einem Wandlerkamm in Form eines Rundpaketes.

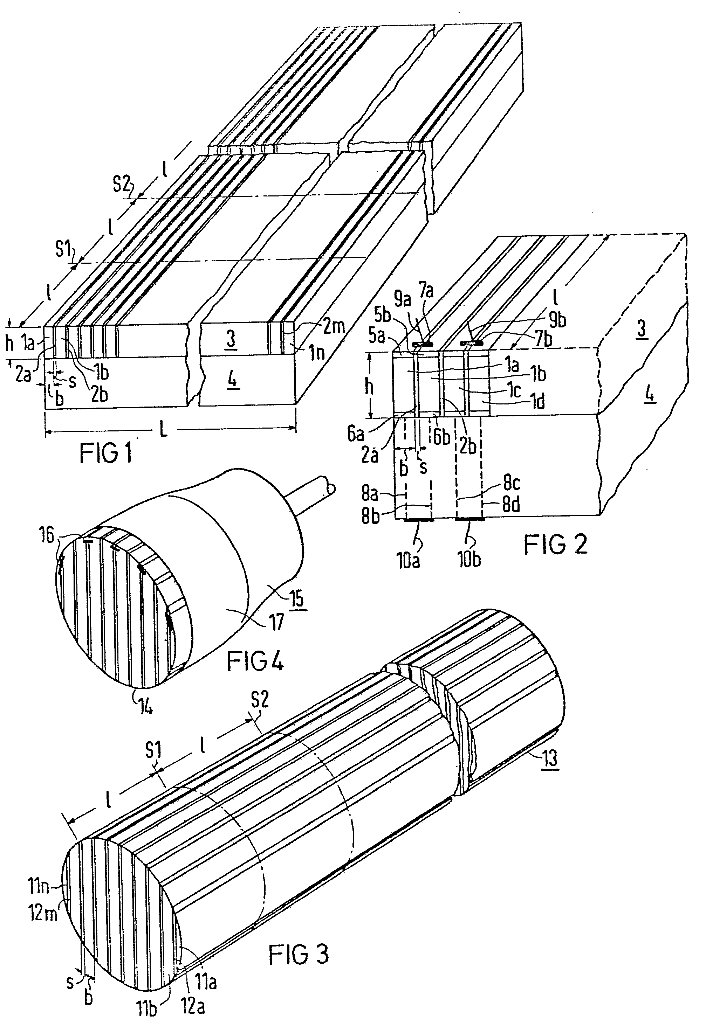

Nach Fig. 1 wird in einem ersten Verfahrensschritt durch wechselweises Aufeinanderstapeln von dünnen Folien 1a bis 1n aus piezoelektrischem Wandlermaterials und Abstandsstreifen 2a bis 2m aus z. B. Epoxydharz in haftender Verbindung ein Folienstapel oder Folienpaket 3 gebildet. Die Dicke der Folien 1a bis 1n ist mit b und die Dicke der Abstandsstreifen 2a bis 2m mit s bezeichnet. Die Folienbreite und die Breite der Abstandsstreifen sind mit h angegeben. Die Gesamthöhe des Pakets 3 nach Aneinanderstapelung (gleich Breite des fertigen Wandlerkammes) beträgt L. Das so gebildete Paket 3 wird anschließend mit einem Trägerteil 4 verbunden. Anschließend erfolgt in einem zweiten Verfahrensschritt durch Sägen oder Schneiden in den Querschnitten S1, S2, etc. das Abschneiden von Einzelpaketen. Die Schnittabstände betragen 1; sie entsprechen den Längen der einzelnen Wandlerkämme.

Wie dargestellt, kann nach Bildung des Pakets 3 zuerst die Zusammenfügung mit dem Trägerteil 4 und anschließend das Schneiden oder Sägen zu Einzelpaketen erfolgen. Ebensogut kann das Paket 3 zuerst in Einzelpakete zerschnitten werden, und anschließend können diese Einzelpakete mit zugeordneten Trägerteilen verbunden werden. Die Einzelfolien aus piezoelektrischem Material (z. B. Barium-Zirkonat-Titanat) sind vorzugsweise vor Zusammenfügung zum Paket 3 an ihren schmalen Längsseiten durch Silberbeläge kontaktbeschichtet. Selbstverständlich kann durch geeignete Aufbringtechnik die Silberkontaktierung auch erst nach Fertigstellung des Pakets 3 erfolgen.

In beiden Fällen ergibt sich dann die in der Fig. 2 in Vergrößerung ausschnittsweise dargestellte Form des Wandlerkammes. Die Folien sind wieder mit 1a bis 1n bezeichnet. Ihre Silberkontaktschichten auf der Oberseite sind mit 5a, 5b etc. und die entsprechenden Silberkontaktschichten an der Unterseite mit 6a, 6b etc. bezeichnet. In der Ausführungsform nach Fig. 1 und 2 weist die Dicke b der Folien 1a, 1b, 1c ... einen Wert auf, der deutlich unterhalb der halben Wellenlänge ($\lambda$/2) der abzustrahlenden bzw. zu empfangenden Ultraschallwellen liegt. Bevorzugt sollte die Dicke b kleiner als $\lambda$/4 sein (b ungefähr 100 µm). Diese Feinunterteilung verbessert erheblich die laterale Auflösung des Wandlerkammes.

Das Kontaktierungsverfahren zeigt speziell Fig. 2. Dort sind die einzelnen Wandlerelemente 1a bis 1n in Gruppen von jeweils zwei benachbarten Elementen kontaktiert. Im Ausführungsbeispiel nach Fig. 2 bilden also die Wandlerelemente 1a und 1b eine erste Gruppe, die Wandlerelemente 1c und 1d eine zweite Gruppe, etc. Die Kontaktierung auf der Oberseite (durch Löten) ist mit 7a, 7b, etc. bezeichnet. Die Kontaktierung der Unterseite erfolgt durch Zusammenlöten der Durchführdrähte 8a, 8b bzw. 8c, 8d, etc. durch den Träger 4 hindurch. An jede Lötkontaktstelle, die einem Wandlerelementpaar zugeordnet ist, sind dann Signalsteuerleitungen 9a, 9b, etc. bzw. 10a, 10b, etc. angeschlossen.

In der Praxis umfaßt das Ultraschall-Array der Fig. 1 und 2 bei einer Ultraschallfrequenz von z. B. f = 2,25 MHz insgesamt 256 Einzelschwinger. Die Breite eines jeden Einzelschwingers ergibt sich bei der gewählten Dicke b der Folien 1a, 1b, ... zu etwa 0,10 mm. Die Höhe der Wandlerelemente (gleich Breite der Folienstreifen) beträgt etwa h = 0,7 mm und die Länge ungefähr l = 11 mm (Paketquerschnitte S1, S2 usw. im Abstand 1). Bei einer Spaltbreite in der Größenordnung von s = 0,05 bis 0,06 mm (gleich Dicke s der Abstandsstreifen) ergibt sich damit bei Zusammenfassung von jeweils zwei Wandlerelementen zu einer Gruppe eine Gruppenbreite von etwa 0,25 mm, wobei die einzelnen Gruppen untereinander entlang der Gesamtbreite L des Wandlerkammes durch Spaltbreiten in der Größenordnung von s = 0,05 bis 0,06 mm getrennt sind.

In den Fig. 1 und 2 haben die Folien und die Abstandsstreifen eine gleichbleibende Breite h. Ebensogut sind jedoch auch andere geometrische Formgebungen möglich. Die Fig. 3 zeigt beispielsweise eine Formation, bei der Folien 11a bis 11n und Abstandsstreifen 12a bis 12m mit variierenden Breiten h so aneinandergefügt sind, daß sich ein Paket 13 mit rundem, im vorliegenden Fall mit kreisförmigem Querschnitt ergibt. Die in Abständen 1 abgeschnittenen Rundpakete können z. B. den Wandlerkamm 14 eines Abtastkopfes 15 für Compound-Scan bilden. Ein solcher Abtastkopf 15 für Compound-Scan ist in der Fig. 4 schematisch dargestellt. Kontaktierungen jeweils benachbarter Wandlerelemente sind mit 16 bezeichnet. Das Trägerteil ist hier mit dem Bezugszeichen 17 versehen.

**Patentansprüche**

1. Verfahren zur Herstellung von Ultraschallköpfen mit einem Trägerteil (4) und einem Wandlerkamm, insbesondere für ein Ultraschall-Array, wobei der Wandlerkamm aus einer vorgebenen Anzahl von aneinandergereihten piezoelektrischen Wandlerelementen vorbestimmter Breite, Höhe und Länge und aus jeweils zwischen benachbarten Wandlerelementen angeordneten Abstandselementen mit vorbestimmter Breite besteht, gekennzeichnet durch die folgenden Verfahrensschritte:

a)   eine der vorgegebenen Anzahl gleiche Zahl von dünnen Folien (1a—1n) aus piezoelektrischem Wandlermaterial wird unter abwechselnder Zwischenlagerung von Abstandsstreifen (2a—2m) in haftender Verbindung zu einem Paket (3) mit der Breite (L) des fertigen Wandlerkammes zusammengefügt, wobei die Dicke (b) der Folien (1a—1n) jeweils genauso groß ist wie die vorbestimmte Breite der Wandlerelemente, wobei die Breite (h) der Folien (1a—1n) jeweils genauso groß ist wie die vorbestimmte Höhe der Wandlerelemente, während die Länge (p1) der Folien ein Mehrfaches (p) der Länge (l) des fertigen Wandlerkammes beträgt, und wobei die Folien (1a—1n) an ihren langgestreckten Längsseiten (Länge p1, Dicke b) durch Silberbeläge (5a, 5b, etc.; 6a, 6b, etc.) kontaktbeschichtet sind;

b)  das Paket (3) wird in eine Vielzahl von Einzelpaketen mit der Länge (l) der fertigen Wandlerkämme zerschnitten;

c)  vor oder nach dem Zerschneiden in Einzelpakete wird das Paket (3) bzw. jedes der Einzelpakete mit einem Trägerteil (4) verbunden; und

d)  die Silberbeläge (5a, 5b, etc.; 6a, 6b, etc.) der Folien (1a—1n) werden mit Signalsteuerleitungen (9a, 9b, etc.; 10a, 10b, etc.) verbunden.

2. Verfahren zur Herstellung von Ultraschallköpfen mit einem Trägerteil (4) und einem Wandlerkamm, insbesondere für ein Ultraschall-Array, wobei der Wandlerkamm aus einer vorgegebenen Anzahl von aneinandergereihten piezoelektrischen Wandlerelementen vorbestimmter Breite, Höhe und Länge und aus jeweils zwischen benachbarten Wandlerelementen angeordneten Abstandselementen mit vorbestimmter Breite besteht, gekennzeichnet durch die folgenden Verfahrensschritte:

a)  eine der vorgegebenen Anzahl gleiche Zahl von dünnen Folien (1a—1n) aus piezoelektrischem Wandlermaterial wird unter abwechselnder Zwischenlagerung von Abstandsstreifen (2a—2m) in haftender Verbindung zu einem Paket (3) mit der Breite (L) des fertigen Wandlerkammes zusammengefügt, wobei die Dicke (b) der Folien (1a—1n) jeweils genauso groß ist wie die vorbestimmte Breite der Wandlerelemente, wobei die Breite (h) der Folien (1a—1n) jeweils genauso groß ist wie die vorbestimmte Höhe der Wandlerelemente, während die Länge (p1) der Folien ein Mehrfaches (p) der Länge (l) des fertigen Wandlerkammes beträgt;

b)  nach Fertigstellung des Paketes (3) werden die Folien (1a—1n) an ihren langgestreckten Längsseiten (Länge p1, Dicke b) durch Silberbeläge (5a, 5b, etc.; 6a, 6b, etc.) kontaktbeschichtet;

c)  das Paket (3) wird in eine Vielzahl von Einzelpaketen mit der Länge (l) der fertigen Wandlerkämme zerschnitten;

d)  vor oder nach dem Zerschneiden in Einzelpakete wird das Paket (3) bzw. jedes der Einzelpakete mit einem Trägerteil (4) verbunden; und

e)  die Silberbeläge (5a, 5b, etc.; 6a, 6b, etc.) der Folien (1a—1n) werden mit Signalsteuerleitungen (9a, 9b, etc.; 10a, 10b, etc.) verbunden.

3. Verfahren zur Herstellung von Ultraschallköpfen mit einem Trägerteil (17) und einem Wandlerkamm, insbesondere für einen Compound-Scanner, wobei der Wandlerkamm aus einer vorgegebenen Anzahl von aneinandergereihten piezoelektrischen Wandlerelementen vorbestimmter Breite, Höhe und Länge und aus jeweils zwischen benachbarten Wandlerelementen angeordneten Abstandselementen vorbestimmter Breite besteht, gekennzeichnet durch die folgenden Verfahrensschritte:

a)  eine der vorgegebenen Anzahl gleiche Zahl von dünnen Folien (11a—11n) aus piezoelektrischem Wandlermaterial wird unter abwechselnder Zwischenlagerung von Abstandsstreifen (12a—12m) in haftender Verbindung zu einem Paket (13) mit dem Querschnitt des fertigen Wandlerkammes (14) zusammengefügt, während die Länge der Folien (11a—11n) und der Abstandsstreifen (12a—12m) ein Mehrfaches (p) der Länge (l) der fertigen Wandlerkämme beträgt;

b)  das Paket (13) wird in eine Vielzahl von Einzelpaketen mit der Länge (l) der fertigen Wandlerkämme (14) zerschnitten;

c)  nach Fertigstellung der Einzelpakete werden die Folien (11a—11n) an ihren Querseiten (Breite h, Dicke b) durch Silberbeläge kontaktbeschichtet; und

d)  jedes Einzelpaket wird mit einem Trägerteil (17) verbunden.

4. Verfahren nach Anspruch 3, dadurch gekennzeichnet, daß die Folien (11a—11n) und die Abstandselemente (12a—12m) mit variierenden Breiten so aneinandergefügt werden, daß sich ein Paket (13) mit rundem, vorzugsweise mit kreisförmigem Querschnitt ergibt.

**Claims**

1. A method of manufacturing ultrasonic transducers, having a carrier component (4) and a comb-shaped transducer unit, in particular for an ultrasonic array, in which the comb-shaped transducer unit consists of a predetermined number of piezoelectric transducer elements of predetermined width, height and length arranged in a row, and of spacer elements of predetermined width arranged in each case between adjacent transducer elements, characterized by the following process steps:

a)  a number, equal to the predetermined number, of thin sheets (1a—1n) of piezoelectric transducer material, alternating with spacer strips (2a—2m) are stuck together to form a packet (3) the width (L) of which is equal to that of the finished comb-shaped transducer unit, where in the thickness (b) of the sheets (1a—1n) is in each case equal to the predetermined width of the transducer elements, and the width (h) of the sheets (1a—1n) is in each case equal to the predetermined height of the transducer elements, whilst the length (p1) of the sheets is a multiple (p) of the length (l) of the finished comb-shaped transducer unit, and wherein the sheets (1a—1n) are coated for contacting at their longitudinal sides (length p1, thickness b) by silver coatings (5a, 5b etc.; 6a, 6b etc.);

b) the packet (3) is divided into a plurality of separate packets the length (l) of which equals that of the finished comb-shaped transducer unit;

c) before or after the division into separate packets, the packet (3) or each of the separate packets is connected to a carrier component (4); and

d) the silver coatings (5a, 5b etc.; 6a, 6b etc.) of the sheets (1a—1n) are connected to signal control lines (9a, 9b etc.; 10a, 10b etc.).

2. A method of manufacturing ultrasonic transducers having a carrier component (4) and a comb-shaped transducer unit, in particular for an ultrasonic array, in which the comb-shaped transducer unit consists of a predetermined number of piezoelectric transducer elements of predetermined width, height and length arranged in a row, and of spacer elements of predetermined width arranged in each case between adjacent transducer elements, characterized by the following process steps:

a) a number, equal to the predetermined number, of thin sheets (1a—1n) of piezoelectric transducer material, alternating with spacer strips (2a, 2m), are stuck together to form a packet (3), the width (L) of which is equal to that of the finished comb-shaped transducer unit, wherein the thickness (b) of the sheets (1a—1n) is in each case equal to the predetermined width of the transducer elements, and the width (h) of the sheets (1a—1n) is in each case equal to the predetermined height of the transducer elements, whilst the length (p1) of the sheets is a multiple (p) of the length (l) of the finished comb-shaped transducer unit;

b) after the completion of the packet (3), the sheets (1a—1n) are coated for contacting with silver coatings (5a, 5b etc.; 6a, 6b etc.) on their longitudinal sides (length p1, thickness b);

c) the packet (3) is divided into a plurality of separate packets the length (l) of which is equal to that of the finished comb-shaped transducer units;

d) before or after the division into separate packets, the packet (3) or each of the separate packets is connected to a carrier component (4); and

e) the silver coatings (5a, 5b etc.; 6a, 6b etc.) of the sheets (1a—1n) are connected to signal control lines (9a, 9b, etc.; 10a, 10b etc.).

3. A method for the manufacture of ultrasonic transducers having a carrier component (17) and a comb-shaped transducer unit, in particular for a compound-scanner, in which the comb-shaped transducer unit consists of a predetermined number of piezoelectric transducer elements of predetermined width, height and length arranged in a row, and of spacer elements of predetermined width arranged in each case between adjacent transducer elements, characterized by the following process steps:

a) a number, equal to the predetermined number, of thin sheets (11a—11n) of piezoelectric transducer material, alternating with spacer strips (12a—12m), are stuck together to form a packet (13), the cross-section of which is equal to that of the finished comb-shaped transducer unit (14), whilst the length of the sheets (11a—11n) and of the spacer strips (12a—12m) is a multiple (p) of the length (l) of the finished comb-shaped transducer units;

b) the packet (13) is divided into a plurality of separate packets, the length (l) of which equals that of the finished comb-shaped transducer units (14);

c) after the completion of the separate packets, the sheets (11a—11n) are for contacting coated by silver coatings on their cross-sectional sides (width h, thickness b); and

d) each separate packet ist connected to a carrier component (17).

4. A method according to claim 3, characterized in that the sheets (11a—11n) and the spacer elements (12a—12m) with varying widths are assembled so as to form a packet (13) of round, preferably circular, cross-section.

## Revendications

1. Procédé pour la fabrication de têtes ultrasonores comportant un élément de support (4) et un transducteur en forme de peigne, en particulier pour un dispositif à ultrasons, le transducteur en forme de peigne étant constitué par un nombre prédéterminé d'éléments transducteurs piézoélectriques alignés les uns à côté des autres et ayant une largeur, une hauteur et une longueur prédéterminées, ainsi que par des éléments d'entretoise de largeur prédéterminée et disposés respectivement entre deux éléments transducteurs voisins, caractérisé par les opérations suivantes:

a) Un nombre, identique au nombre prédéterminé, de feuilles minces (1a—1n) en un matériau transducteur piézoélectrique, est assemblé, avec interposition alternée de bandes-entretoises (2a—2m), selon une liaison adhérente pour former un paquet (3) ayant la largeur (L) du transducteur terminé en forme de peigne, l'épaisseur (b) de chacune des feuilles (1a—1n) étant exactement identique à la largeur prédéterminée des éléments transducteurs, alors que la largeur (h) de chacune des feuilles (1a—1n) est exactement indentique à la hauteur prédéterminée des éléments transducteurs, que la longeur (p1) des feuilles est égale à un multiple (p) de la longueur (l) du transducteur terminé en forme de peigne et que les feuilles (1a—1n) sont revêtues sur leurs côtés longitudinaux allongés (longueur p1, épaisseur b) de couches d'argent (5a, 5b etc; 6a, 6b, etc) servant de contacts,

b) Le paquet (3) est découpé en plusieurs paquets individuels de la longueur (1) des transducteurs terminés en forme de peigne;

c) Avant ou après le découpage en les paquets individuels, le paquet ou chacun des paquets individuels est relié à un élément de support (4); et

d) Les revêtements en argent (5a, 5b, etc; 6a, 6b, etc) des feuilles (1a—1n) sont reliés à des conducteurs de commande de signaux (9a, 9b etc; 10a, 10b, etc).

2. Procédé pour la fabrication de têtes ultrasonores comportant un élément de support (4) et un transducteur en forme de peigne, en particulier pour un dispositif à ultrasons, le transducteur en forme de peigne étant constitué par un nombre prédéterminé d'éléments transducteurs piézoélectriques alignés les uns à côté des autres et ayant une largeur, une hauteur et une longueur prédéterminées, ainsi que par des éléments d'entretoise de largeur prédéterminée et disposés respectivement entre deux éléments transducteurs voisins, caractérisé par les opérations suivantes:

a) Un nombre identique au nombre prédéterminé de feuilles minces (1a—1n) en un matériau transducteur piézoélectrique est assemblé, avec interposition alternée de bandes-entretoises (2a—2m), selon une liaison adhérente, pour former un paquet (3) ayant la largeur (L) du transducteur terminé en forme de peigne, l'épaisseur (b) de chacune des feuilles (1a—1n) étant exactement identique à la largeur prédéterminée des éléments-transducteurs, alors que la largeur (h) de chacune des feuilles (1a—1n) est exactement identique à la hauteur prédéterminée des éléments transducteurs, et que la longueur (p1) des feuilles est égale à un multiple (p) de la longueur (l) du transducteur terminé en forme de peigne;

b) après la réalisation du paquet (3), les feuilles (1a—1n) sont revêtues sur leurs côtés longitudinaux allongés (longueur p1, épaisseur b) de couches d'argent (5a, 5b, etc; 6a, 6b, etc) servant de contacts;

c) le paquet (3) est découpé en plusieurs paquets individuels de la longueur (1) des transducteurs terminés en forme de peigne;

d) avant ou après le découpage en des paquets individuels, le paquet (3) ou chacun des paquets individuels est relié à un élément de support (4); et

e) les revêtements en argent (5a, 5b, etc; 6a, 6b, etc) des feuilles (1a—1n) sont reliés à des conducteurs de commande de signaux (9a, 9b etc; 12a, 10b, etc).

3. Procédé pour la fabrication de têtes ultrasonores comportant un élément de support (17) et un transducteur en forme de peigne, en particulier pour un Scanner du type compound, le transducteur en forme de peigne étant constitué par un nombre prédéterminé d'éléments transducteurs piézoélectriques alignés les uns à côté des autres et ayant une largeur, une hauteur et une longueur prédéterminées, ainsi que par des éléments d'entretoise de largeur prédéterminée et disposés respectivement entre deux éléments transducteurs voisins, caractérisé par les opérations suivantes:

a) un nombre, identique au nombre prédéterminé, de feuilles minces (1a—1n) en un matériau transducteur piézoélectrique est assemblé, avec interposition alternée de bandes-entretoises, (2a—2m) selon une liaison adhérente pour former un paquet (3) ayant la section du transducteur terminé en forme de peigne, alors que la longueur des feuilles (11a—11n) et des bandes d'entretoise (12a—12m) est égale à un multiple (p) de la longueur (1) des transducteurs en forme de peignes terminés;

b) le paquet (13) est découpé en plusieurs paquets individuels de la largeur (1) des transducteurs terminés en forme de peignes (14);

c) après la réalisation des paquets individuels, les feuilles (11a—11n) sont revêtues sur leurs côtés transversaux (largeur h, épaisseur b) de couches d'argent servant de contacts; et

d) chaque paquet individuels est relié à un élément de support (17).

4. Procédé selon la revendication 3, caractérisé par le fait que les feuilles (11a—11n) et les éléments d'entretoise (12a—12m) sont, avec des largeurs variables, assemblés côte à côte de manière qu'il en résulte un paquet (13) de section ronde, de préférence circulaire.

FIG 1

FIG 2

FIG 4

FIG 3